# EUROPÄISCHE PATENTSCHRIFT

(11) **EP 4 253 214 B1**
(45) Veröffentlichungstag und Bekanntmachung des Hinweises auf die Patenterteilung: **29.01.2025**
(21) Anmeldenummer: 23164250.5
(22) Anmeldetag: 27.03.2023
(51) Int. Cl.: B62K 21/26

(54) **HANDGRIFF MIT NÄHERUNGSSENSOR FÜR MOTORGETRIEBENE FAHRZEUGE**
HANDGRIP WITH PROXIMITY SENSOR FOR MOTOR-DRIVEN VEHICLES
POIGNÉE POUR VÉHICULES À MOTEUR AVEC DÉTECTEUR DE PROXIMITÉ

(30) Priorität: 31.03.2022 DE 102022107701
(43) Veröffentlichungstag der Anmeldung: 04.10.2023
(73) Patentinhaber: brehmerinnovations B.V., 6541 TV Nijmegen (NL)
(72) Erfinder: Schmidt, Moritz, 51107 Köln-Rath (DE); Brehmer, Thomas, 51674 Wiehl (DE)
(74) Vertreter: Lippert Stachow Patentanwälte Rechtsanwälte

(56) Entgegenhaltungen:
- EP-B1- 2 021 214
- WO-A1-2006/102877
- DE-A1- 102017 110 118
- US-A1- 2019 077 311

## Beschreibung

Die Erfindung betrifft einen Handgriff für einen Lenker eines Motorfahrzeuges wie ein Motorrad, Wassermotorrad, Motorschlitten, Quad und dergleichen, umfassend ein hohlzylinderartiges Innenteil mit einer Außenmantelseite und einer Innenmantelseite, eine radial außen zur Außenmantelseite des Innenteils angeordnete Sensorelektrode sowie ein radial au-ßen zur Außenmantelseite des Innenteils angeordnetes, angegossenes oder angespritztes Verkleidungselement, welches die Sensorelektrode abdeckt, wobei eine Näherungssensorschaltung mit der Sensorelektrode elektrisch verbunden ist.

Ein solcher gattungsbildender Handgriff ist in der Patentschrift EP 2 021 214 B1 offenbart. In Abhängigkeit des Ausgangssignals der Näherungssensorschaltung kann ein solcher gattungsbildender Handgriff für einen Lenker beispielsweise zur Steuerung eines Kraftradlenkstangen-Sperrsystems eingesetzt werden. Zu dem gattungsbildenden Handgriff ist gelehrt, die Näherungssensorschaltung im Innern des Innenteils anzuordnen, wobei elektrische Verbindungsleitungen durch zugeordnete radial verlaufende Durchführungen durch das Innenteil dazu dienen, entsprechende Kontakte zur Verbindung mit einer zentralen Steuereinrichtung des Motorfahrzeuges bereitzustellen.

Diese Anordnung des gattungsgemäßen Handgriffs für einen Lenker eines Motorfahrzeuges ist sowohl in Bezug auf die Gestaltung bzw. den Aufbau als auch in Bezug auf die Montage vergleichsweise aufwendig. Insofern liegt der vorliegenden Erfindung die Aufgabe zugrunde, einen gattungsbildenden Handgriff in Bezug auf seinen Aufbau als auch in Bezug auf seine Montage und damit bezüglich der Herstellungskosten zu verbessern. Diese Aufgabe wird mit einem Handgriff umfassend die Merkmale von Anspruch 1 gelöst.

Der erfindungsgemäße Handgriff für einen Lenker eines Motorfahrzeuges weist ein hohlzylinderartiges Innenteil mit einer Außenmantelseite und einer Innenmantelseite auf, eine radial außen zur Außenmantelseite des Innenteils angeordnete Sensorelektrode, insbesondere zur Bereitstellung eines kapazitiven Feldes, sowie ein radial außen zur Außenmantelseite des Innenteils angeordnetes, angegossenes oder angespritztes Verkleidungselement, welches die Sensorelektrode abdeckt, wobei eine Näherungssensorschaltung (Sensorschaltung) mit der Sensorelektrode elektrisch verbunden ist. Dabei kann die Sensorschaltung ausgebildet und eingerichtet sein, ein Präsenzsignal zur Anzeige einer Präsenz bzw. einer Annäherung, insbesondere einer Hand, zum Handgriff zu ermitteln. Der erfindungsgemäße Handgriff zeichnet sich dadurch aus, dass sowohl die Sensorelektrode als auch die Sensorschaltung auf einem gemeinsamen Träger einer Leiterplatte, angeordnet sind, wobei der gemeinsame Träger das Innenteil umgreift, insbesondere um mehr als 3/4 einer vollumfänglichen Umgreifung, und der Träger mit zumindest einem ersten Abschnitt, in welchem dieser flexibel ausgebildet ist, direkt oder indirekt an einem zylinderförmigen Außenmantelflächenabschnitt des Innenteils anliegt und das Innenteil an seiner Außenmantelseite zumindest einen radial nach außen weisenden Vorsprung aufweist, der sich durch einen zugeordneten Lochabschnitt des ersten Abschnittes des Trägers der Leiterplatte erstreckt.

Durch die erfindungsgemäße Anordnung der Sensorelektrode eines Näherungssensors und der zugeordneten Sensorschaltung auf einem zumindest abschnittsweise flexiblen Träger einer damit zumindest abschnittsweise flexiblen Leiterplatte vereinfacht sich die Gestaltung der Sensoranordnung da im Gegensatz zum Stand der Technik Sensorelektrode und Sensorschaltung auf einem gemeinsamen Träger der Leiterplatte angeordnet sind, wobei die Leiterplatte mit zumindest einem flexiblen Abschnitt des Trägers direkt oder indirekt an einem zugeordneten zylinderförmigen Außenmantelflächenabschnitt des Innenteils anliegt. Die beschriebene Gestaltung hat insbesondere auch Vorteile in Bezug auf die Vermeidung bzw. Verminderung des Einflusses von Störgrößen auf das erfasste Präsenzsignal, da durch die Anordnung der Sensorelektrode und der Sensorschaltung auf einem gemeinsamen Träger, und damit auf einer gemeinsamen Leiterplatte, Verbindungsleitung zwischen Sensorelektrode und Sensorschaltung sehr kurz gehalten werden können im Unterschied zu der Gestaltung im gattungsgemäßen Handgriff, bei welchem eine elektrische Verbindung von der Außenmantelseite des Innenteils zu der Innenmantelseite des Innenteils bereitgestellt werden muss. Vorteilhaft kann bei dem erfindungsgemäßen Handgriff vorgesehen sein, dass der gemeinsame Träger und damit auch die gemeinsame Leiterplatte vollständig radial außen zur Außenmantelfläche des Innenteils angeordnet ist, wodurch derartige Störeinflüsse, wie sie beim gattungsgemä-ßen Handgriff auftreten können, vermieden werden können. Darüber hinaus ist der Zusammenbau des erfindungsgemäßen Handgriffs erleichtert, wobei durch den beschriebenen Formschluss zwischen Innenteil und flexibler Leiterplatte, der durch den sich durch einen zugeordneten Lochabschnitt der flexiblen Leiterplatte hindurch erstreckenden Vorsprung bereitgestellt ist, eine exakte gegenseitige Anordnung der Bauteile zueinander sichergestellt ist, insbesondere beim Angießen bzw. Anspritzen des Verkleidungselementes, jedoch auch beim Auftreten erhöhter äußerer Betriebskräfte.

Der Begriff "flexibler Abschnitt des Trägers oder flexibler Abschnitt der Leiterplatte" meint grundsätzlich einen biegsamen Abschnitt des Trägers bzw. einen biegsamen Abschnitt der Leiterplatte im Unterscheid zu einer herkömmlichen, starren Leiterplatte bzw. einem starren Träger einer Leiterplatte, wie sie bzw. er z.B. bei einer herkömmlichen FR4-Leiterplatte vorliegt. Der gemeinsame Träger kann zur Bereitstellung einer Flexibilität bzw. Biegefähigkeit beispielsweise eine Polyamid-Lage, eine Polyimid-Lage, eine Fasergewebelage, insbesondere eine Glasfasergewebelage umfassen bzw. als solche ausgebildet sein. Diese insbesondere der Sensorelektrode und der Sensorschaltung gemeinsame Trägerlage aus dem jeweiligen Material kann sich insofern durchgehend über die gesamte Leiterplatte als Lage der Leiterplatte erstrecken.

Der Begriff Träger kann allgemein als Trägerlage und Trägerschicht verstanden werden, wobei der Träger auch mehreren Teillagen oder Teilschichten, insbesondere aus unterschiedlichen Materialien, z.B. in Form einer Sandwich-Struktur umfassen kann. Insofern werden im Folgenden die Begriffe Träger, Trägerlage und Trägerschicht gleichbedeutend verwendet.

Grundsätzlich ist der Begriff "Sensorelektrode" breit zu verstehen und kann je nach spezifischem Näherungssensor unterschiedliche Gestaltungen aufweisen. In solchen Fällen, in welchen der Näherungssensor als kapazitiver Sensor ausgebildet ist, kann die Sensorelektrode beispielsweise einen flächigen Leiter aufweisen, wobei dieser flächige Leiter auch als Leiterbahn ausgebildet sein kann. In solchen Fällen, in welchen der Näherungssensor als induktiver Sensor ausgebildet ist, kann die Sensorelektrode beispielsweise eine Induktivität wie eine Leiterspule umfassen. Wie der Fachmann erkennt, kann der erfindungsgemäße Handgriff auch mit anderen Arten von Näherungssensoren ausgebildet sein.

Je nach spezifischem Sensor kann die von der Sensorelektrode aufgenommene physikalische Größe in der zugeordneten Sensorschaltung in ein Sensorsignal, insbesondere ein elektrisches Sensorsignal umgewandelt werden, das insofern eine Präsenz/Nichtpräsenz bzw. eine Annäherung/Nichtannäherung an den Handgriff anzeigen kann. Ein Näherungssensor kann eine solche Sensorelektrode sowie die zugeordnete und insbesondere mit dieser elektrisch verbundene Sensorschaltung umfassen bzw. durch diese gebildet sein.

Eine Sensorschaltung eines am bzw. im Handgriff angeordneten Näherungssensor kann einen elektrischen Oszillator aufweisen, der im Fall eines kapazitiven Näherungssensors eine frequenzbestimmende Kapazität umfassen kann, die durch die Annäherung eines Körpers oder Gegenstandes zur Sensorelektrode veränderbar ist, was durch die Sensorschaltung erfassbar ist. In ähnlicher Weise kann im Falle eines induktiven Näherungssensors ein elektrischer Oszillator der Sensorschaltung eine frequenzbestimmende Induktivität aufweisen, die durch die Annäherung eines Körperteils wie einer Hand oder eines Gegenstandes zur Sensorelektrode veränderbar ist, was wiederum durch die Sensorschaltung erfassbar ist.

Erfindungsgemäß kann die Sensorschaltung zur Ermittlung und Ausgabe eines Sensorsignals ausgebildet sein. Dieses Sensorsignal, das im Folgenden auch Präsenzsignal oder Näherungssignal bezeichnet wird, kann z.B. ein digitales Signal sein, insbesondere zur Anzeige oder zur Nichtanzeige einer Präsenz in der Art einer ja/nein-Angabe. In einer anderen Ausführungsform kann auch vorgesehen sein, dass am Ausgang der Sensorschaltung ein analoges Signal ausgegeben wird.

Grundsätzlich kann die Sensorschaltung eine Mehrzahl oder auch alle elektronischen Bauteile aufweisen zur Ermittlung und Ausgabe eines jeweiligen Sensorsignals. Sensorelektrode und Sensorschaltung können insofern den Sensor bildet.

Weitere erfindungsgemäße Merkmale und Weiterbildungen sind in der nachfolgenden allgemeinen Beschreibung, den Figuren, der Figurenbeschreibung sowie den Unteransprüchen angegeben.

Es kann vorgesehen sein, die auf dem gemeinsamen Träger bzw. der gemeinsamen Leiterplatte angeordnete Sensorschaltung zumindest abschnittsweise, insbesondere vollständig im Material des Verkleidungselementes einzubetten. Beispielsweise kann die Verwendung eines witterungsbeständigen Werkstoffes als Material des Verkleidungselementes, insbesondere ein allgemein als Gummi bezeichnetes Vulkanisat von Natur- oder Synthesekautschuken, dafür Sorge tragen, dass die auf der flexiblen Leiterplatte angeordnete Sensorschaltung hermetisch gegen Witterungseinflüsse geschützt ist und gleichzeitig dem Fahrer ein Griffabschnitt zum Angreifen an den Lenker des Motorfahrzeuges bereitgestellt ist.

Zum elektrischen Anschließen der zumindest in einem Abschnitt flexiblen Leiterplatte bzw. der darauf angeordneten Schaltung wie der Sensorschaltung an eine Versorgungseinrichtung wie eine Batterie und/oder zum Verbinden an eine zentrale Steuereinrichtung des Motorfahrzeuges, kann zweckmäßigerweise eine außerhalb des Verkleidungselementes angeordnete und mit der Leiterplatte elektrisch verbundene elektrische Anschlusseinrichtung vorgesehen sein. Es kann vorgesehen sein, dass die Anschlusseinrichtung auf dem gemeinsamen Träger der Leiterplatte und damit auf der Leiterplatte angeordnet ist. Eine solche Anschlusseinrichtung kann beispielsweise eine Steckereinrichtung oder Buchseneinrichtung umfassen oder in einer einfachen Ausführungsform eine vorgegebene Anzahl von elektrischen Leitungen in Form von Kabeln, die sich aus dem Verkleidungselement heraus erstrecken können. Es kann vorgesehen sein, dass die Leiterplatte, auf welcher zumindest die Sensorelektrode und die Sensorschaltung angeordnet sein können, mit einem Anschlussabschnitt aus dem Verkleidungselement herausragt und auf diesem Anschlussabschnitt eine elektrische Anschlusseinrichtung angeordnet ist, beispielsweise in Form von Kontakten oder umfassend Kontakte, die mittels einer komplementär ausgebildeten Anschlusseinrichtung abtastbar angeordnet sein können.

Je nach Ausführungsform kann die Anschlusseinrichtung eine Mehrzahl von solchen elektrischen Kontakten aufweisen. Beispielsweise kann die Anschlusseinrichtung drei elektrische Kontakte umfassen, insbesondere zwei Versorgungskontakte und einen Signalkontakt, letzteres zur Signalausgabe eines Präsenzsignals und/oder eines Steuersignals. Darüber hinaus sind auch Ausführungen im Rahmen der Erfindung möglich mit mehr als drei Kontakten insbesondere bei Anwendungen, bei welchen weitere Betriebsfunktionen auf der Leiterplatte, insbesondere in Form einer zugeordneten elektronischen Schaltung angeordnet sind. Ist beispielsweise auf der zumindest abschnittsweise flexiblen Leiterplatte neben einer Näherungssensorschaltung darüber hinaus eine Heizungsschaltung zum Heizen des Handgriffs angeordnet, kann die Anschlusseinrichtung des erfindungsgemäßen Handgriffs beispielsweise vier oder fünf Kontakte aufweisen: einen Kontakt für die gemeinsame Masse, einen Kontakt für die Versorgung der Heizung, einen Kontakt für die elektrische Versorgung der Näherungssensorschaltung sowie einen Kontakt zur Bereitstellung eines Ausgangssignals und/oder Steuersignals an eine externe Steuereinrichtung. Insbesondere der letztgenannte Kontaktanschluss kann auch als Buskontakt ausgebildet sein zum Anschluss an einen Datenbus des Motorfahrzeuges, beispielsweise eines CAN (Controller Area Network) -Bus. Dabei kann vorgesehen sein, dass die Anschlusseinrichtung des erfindungsgemäß gestalteten Handgriffs eine Busschnittstelle aufweist, die je nach Ausführungsform unidirektional oder bidirektional arbeitend ausgebildet sein kann.

In einer zweckmäßigen Ausführungsform kann vorgesehen sein, dass die Sensorschaltung einen Mikrocontroller aufweist, der ausgebildet und angeordnet ist, die Sensorelektrode des Näherungssensors abzutasten. Dabei kann vorgesehen sein, dass der Mikrocontroller zur Ermittlung eines Präsenzsignals und zur ausgangsseitigen Ausgabe des ermittelten Präsenzsignals ausgebildet ist oder das ermittelte Präsenzsignal intern zu verarbeiten und beispielsweise in Abhängigkeit des ermittelten Präsenzsignals eine Betriebsfunktion auszulösen und/oder ein Steuersignal bereitzustellen für eine externe Steuereinrichtung des Motofahrzeuges. Dabei kann der Mikrocontroller ausgebildet sein, ein analoges oder digitales Präsenzsignal, und/oder auch ein analoges oder digitales Steuersignal ermitteln und insbesondere an einen seiner Ausgänge ausgeben.

Es kann vorgesehen sein, dass die Sensorschaltung bzw. der Mikrocontroller ausgebildet und eingerichtet ist, ein Präsenzsignal zu ermitteln, dass einen größeren Informationsgehalt als einen "1 Bit"- Informationsgehalt aufweist, z.B. angibt, in welchem von mehreren, beispielsweise drei, vier oder fünf Abstandsabschnitten eine Annäherung oder Präsenz zum Handgriff vorliegt.

Es kann vorgesehen sein, dass die auf der Leiterplatte angeordnete Sensorschaltung eingerichtet und ausgebildet ist, nicht nur eine Annäherung zu erfassen, sondern auch eine Umschließung, d.h. eine Umgreifung des erfindungsgemäßen Handgriffs mit einer Hand und/oder verschiedene Handpositionen zum Handgriff zu erfassen. Dabei kann vorgesehen sein, dass der Näherungssensor als Mehrfachsensor ausgebildet ist, um für mehrere, insbesondere in Einbaulage umfänglich beanstandete bzw. benachbarte Umfangsabschnitte am Handgriff jeweils ein zugeordnetes Präsenzsignal zu ermitteln, und ferner eingerichtet und ausgebildet ist, aus dieser Mehrzahl von Präsenzsignalen zu ermitteln, welche spezifischen Lage eine Hand zum erfindungsgemäßen Handgriff einnimmt.

Hierzu können mehrere Sensorelektroden, die insbesondere in Einbaulage der Leiterplatte umfänglich beabstandet auf einem flexiblen Abschnitt des Träger angeordnet sein können, wobei jeweils ein zugeordneter Oszillator zur jeweiligen Erfassung eines Präsenzsignals, dass einem Umfangsabschnitt am erfindungsgemäßen Handgriff zugeordnet ist, sodass für mehrere Umfangsabschnitte der Leiterplatte bzw. mehrere Sensorelektroden, die um das Innenteil herum angeordnet sind, ein jeweiliges Präsenzsignal ermittelbar ist, und aus der Mehrzahl von im Wesentlichen zeitgleich erfassten Präsenzsignalen ein zusammengesetztes Präsenzsignal ermittelbar ist, dass eine relative Lage, insbesondere eine relative Lage einer Hand zum Handgriff anzeigt bzw. wiedergibt. Ein solches zusammengesetztes Präsenzsignal kann insbesondere eine Mehrzahl von Parameterwerten umfassen und nicht auf die Angabe eines Werteparameters beschränkt sein.

Damit der erfindungsgemäße Handgriff auch beim Auftreten von in axialer Richtung zum Innenteil wirkenden Betriebskräften funktionstüchtig bleibt, kann vorgesehen sein, dass das Innenteil an seiner Außenmantelfläche zumindest einen radial nach außen weisenden und sich umfänglich erstreckenden Steg aufweist, der im Verkleidungselement eingebettet ist und sich durch einen zugeordneten Lochabschnitt im ersten Abschnitt des Trägers erstrecken kann. Hierdurch kann zum einen ein axiales Abziehen des Verkleidungselementes vom Innenteil und gleichzeitig auch beim Auftreten von entsprechenden Betriebskräften eine vorgegebene relative Anordnung der Bauteile zueinander beibehalten und damit ein Aufrechterhalten vorgegebener Funktionalitäten des Handgriffs bereitgestellt werden.

Wie obenstehend schon angegeben, kann der erfindungsgemäße Handgriff zur Bereitstellung weiterer Betriebsfunktionen ausgebildet sein, beispielsweise zur Bereitstellung einer Heizungsfunktion, wobei eine Heizungseinrichtung angeordnet und eingerichtet sein kann, einen vom Nutzer umgriffenen Bereich des Handgriffs, insbesondere einen bzw. den Bereich des Verkleidungselementes, zu erwärmen. Hierzu kann insbesondere ein weiterer, von der Sensorelektrode bzw. den Sensorelektroden des Näherungssensors isoliert angeordneter Leiterbahnabschnitt auf dem ersten, flexiblen Abschnitt des Trägers der Leiterplatte angeordnet sein, der einer solchen Heizungsfunktion zugeordnet ist und zumindest eine Widerstandsbahn zur Erzeugung elektrischer Verlustwärme aufweist. Um über einen großen Oberflächenabschnitt des Handgriffs eine entsprechende Wärmeabgabe bereitzustellen, kann vorgesehen sein, dass die zumindest eine auf dem flexiblen Abschnitt des Trägers angeordnete Widerstandsbahn mäanderförmig angeordnet ist, wobei Mäanderarme im Wesentlichen parallel und/oder senkrecht zur Längsachse des Handgriffs verlaufen können. In dieser Ausführungsform kann die elektrische Anschlusseinrichtung ferner den schon obenstehend beschriebenen zumindest einen Heizungskontakt aufweisen, der mit der zumindest einen Widerstandsbahn elektrisch verbunden ist.

Es kann vorgesehen sein, dass die auf der Leiterplatte angeordnete Sensorschaltung als Sensorauswerteschaltung ausgebildet ist, welche das erfasste Signal auswertet und nach vorgegebenen Kriterien feststellt, ob der jeweilige Handgriff von einem Nutzer berührt ist oder sich dieser, insbesondere mit seiner Hand, dem Handgriff nähert, oder sich über einen vorgegebenen Schwellenwert hinaus vom Griff entfernt hat. Eine solche Auswertung kann durch Vergleich mit in einem Speicher, insbesondere einem Speicher des Mikrocontrollers, abgelegten, vorbestimmten Schwellwerten des erfassten Sensorsignals durchgeführt werden.

Die Anzahl von elektrischen Bauelemente der Sensorschaltung können zumindest teilweise, insbesondere überwiegend, auf einem zweiten Abschnitt des Trägers der Leiterplatte angeordnet sein, der zu dem, an einem zylinderförmigen Außenflächenabschnitt des Innenteils anliegenden ersten, flexiblen Abschnitts des Trägers der Leiterplatte verschwenkt ist, insbesondere radial nach außen relativ zum Innenteil verschwenkt sein kann. Diese Verschwenkung der ersten und zweiten Abschnitte des Trägers bzw. der Leiterplatte zueinander kann durch die Flexibilität des ersten Abschnittes des Trägers bereitgestellt werden, der insofern eine Art Filmscharnier zum zweiten Abschnitt des Trägers bereitstellen kann, was es erlaubt, den ersten Abschnitt zum zweiten Abschnitt zu verschwenken, wobei die Schwenkachse in einer Betriebsposition des Handgriffs etwa senkrecht zur Längsachse des Innenteils verlaufen kann. Diese Verschwenkung ermöglicht die zumindest abschnittsweise Anordnung der Sensorschaltung, beispielsweise eines Mikrocontrollers der Sensorschaltung in einem Abschnitt, insbesondere dem zweiten Abschnitt der Leiterplatte, der im Betrieb keiner mechanischen Belastung, die beispielsweise durch das Umgreifen des Griffs durch den Nutzer erzeugt werden kann, ausgesetzt wird. Dieses Verschwenken der genannten Abschnitte der Leiterplatte zueinander kann insbesondere um etwa 90° erfolgen, sodass sich der verschwenkte Abschnitt der Leiterplatte etwa radial zur Achse des Innenteils erstrecken kann.

Beispielsweise kann vorgesehen sein, dass an oder in einer radialen, insbesondere senkrecht zur Achse des Innenteils ringförmig umlaufende Wulst des Verkleidungselementes, die insbesondere den durch einen Fahrer genutzten Umgreifungsbereich des Handgriffs axial beschränken kann, der jeweilige Abschnitt der Leiterplatte, welcher zumindest abschnittsweise die Sensorschaltung, insbesondere die gesamte Sensorschaltung bzw. deren gesamte elektrische Bauteile umfassen kann, angeordnet ist. Dabei kann vorgesehen sein, dass ein die Sensorschaltung zumindest abschnittsweise oder vollständig umfassender Abschnitt der Leiterplatte an einem sich umfänglich erstreckenden Radialsteg des Innenteils angeordnet ist und dort zusammen mit dem Radialsteg von Material des Verkleidungselementes zur Bildung der radialen, ringförmigen Wulst eingebettet ist. Es kann vorgesehen sein, dass der radial verschwenkte Abschnitt der Leiterplatte an diesem umfänglich sich erstreckenden Radialsteg des Innenteils anliegt und/oder daran befestigt ist.

Die Stabilität des erfindungsgemäßen Handgriffs gegenüber auftretenden Betriebskräften, kann weiter erhöht werden, wenn das Innenteil an seiner Außenmantelseite mehrere radial nach außen weisende Vorsprünge umfasst, wobei diese Vorsprünge zueinander an der Außenmantelseite des Innenteils in Längsrichtung beabstandet angeordnet sind und sich durch einen jeweiligen zugeordneten Lochabschnitt des flexiblen Abschnittes des Trägers erstrecken, sodass die besagte relative Anordnung der Bauteile über einen überwiegenden Anteil der axialen Länge, insbesondere über die gesamte axiale Länge des erfindungsgemäßen Handgriffs, die vom Fahrer umgreifbar ist, bereitgestellt werden kann.

Wie obenstehend schon angegeben, kann vorgesehen sein, dass die Näherungssensorschaltung auf einem zweiten Abschnitt des flexiblen Trägers der Leiterplatte angeordnet ist, der zu dem, am zylinderförmigen Außenmantelflächenabschnitt des Innenteils anliegenden ersten, flexiblen Abschnitt des Trägers der Leiterplatte umgeschwenkt, beispielsweise um einen Winkel zwischen 60° und 110°, insbesondere um einen Winkel von etwa 90° umgeschwenkt ist, beispielsweise derart, dass er sich etwa radial zum Innenteil nach außen erstreckt.

In einer Ausführungsform kann die Leiterplatte über Ihre gesamte Flächenerstreckung als Tragstruktur allein den flexiblen Träger aufweisen, auf welchen insbesondere schaltungsbezogene Leiterbahnen sowie schaltungsbezogene elektrische Bauelemente angeordnet sein können. In dieser Ausführungsform kann insofern sowohl der Träger als auch die Leiterplatte, insbesondere über ihre gesamte Flächenerstreckung als solche flexibel, d.h. biegsam ausgebildet sein.

Die Erfindung ist jedoch nicht auf die Verwendung eines solchen durchgehend flexiblen Trägers bzw. einer durchgehend flexiblen Trägerlage und damit einer solchen durchgehenden flexiblen Leiterplatte beschränkt. Beispielsweise kann auch vorgesehen sein, dass die den flexiblen ersten Abschnitt des Trägers aufweisende Leiterplatte zumindest einen starren Abschnitt aufweist, in welchem der Träger mit einer starren Verstärkungslage verbunden ist, insbesondere stoffschlüssig verbunden ist.

Es kann vorgesehen sein, dass die an sich flexible Trägerlage sich im Wesentlichen über die gesamte Fläche der Leiterplatte erstreckt, wobei der mit der starren Verstärkungslage versehene Abschnitt des Trägers aufgrund der Verbindung mit der Verstärkungslage mit dieser unbiegsam, d.h. starr ist. Die Verstärkungslage kann z.B. ein homogenes Plattenelement, jedoch auch ein Laminatverbund in Form einer Sandwich-Struktur mit einer Mehrzahl von miteinander verbundenen Schichten umfassen.

Insbesondere kann vorgesehen sein, dass der Verstärkungsabschnitt des Trägers der zweite Abschnitt des Trägers ist, auf welchem elektrische Bauteile und Leiterbahnen der Sensorschaltung bzw. die Sensorschaltung angeordnet sind bzw. ist. In dieser Ausführungsform kann insofern die Leiterplatte einen flexiblen Abschnitt umfassen, welcher tragseitig allein die flexible Trägerlage umfasst und insbesondere den ersten Abschnitt des Trägers darstellt, welcher das Innenteil umgreift bzw. an diesem direkt oder indirekt anliegt, während ein Leiterplattenbereich, auf welchem zumindest die überwiegende Anzahl der elektrischen Bauteile der Näherungssensorschaltung, insbesondere die gesamte Sensorschaltung angeordnet ist, durch das Vorsehen der beschriebenen Verstärkungslage starr ausgebildet sein kann. Diese Ausgestaltung ist insbesondere in solchen Ausführungsformen zweckmäßig, bei welchen die Sensorschaltung und/oder eine Temperaturschaltung auf einem zum ersten Abschnitt umgeschwenkten zweiten Abschnitt des Trägers angeordnet ist bzw. sind, wobei dieser zweite Abschnitt beispielsweise in einer radialen, ringförmigen Wulst des Verkleidungselementes eingebettet sein kann.

Es kann vorgesehen sein, dass die Anschlusseinrichtung im zweiten Abschnitt des Trägers angeordnet ist, insbesondere im Bereich der Verstärkungslage des flexiblen Trägers und damit im Bereich eines starren Abschnittes der Leiterplatte, auf welchem elektrische Bauteile und Leiterbahnen der Sensorschaltung bzw. die Sensorschaltung angeordnet sein können. Es ist jedoch im Rahmen der Erfindung auch möglich, dass die Anschlusseinrichtung auf einem dritten Abschnitt des Trägers der Leiterplatte angeordnet ist, der sich von dem, in Einbaulage am zylinderförmigen Außenmantelflächenabschnitt des Innenteils anliegenden ersten Abschnitt des Trägers erstreckt und wie der erste Abschnitt des Trägers flexibel ausgebildet sein kann, sodass die Leiterplatte im ersten und im dritten Abschnitt flexibel ausgebildet sein kann. Dabei kann der dritte Abschnitt des Trägers in Betriebsposition, d. h. in Einbaulage einen etwa parallel zur Längsachse des Innenteils erstreckenden, insbesondere geradlinigen Längsstreifen und einen sich daran anschließenden und mit diesem einen Winkel von etwa 90 Grad bildenden, und insbesondere geradlinigen Querstreifen aufweisen. Der Querstreifen kann sich in Einbaulage umfänglich um das Innenteil herumgewickelt erstrecken, und an dessen freien Ende die Anschlusseinrichtung angeordnet sein. Das Vorsehen dieses dritten Abschnitts des Trägers bzw. der Leiterplatte kann insbesondere bei der Gestaltung eines Gasgriffes zweckmäßig sein, bei dem das Innenteil zu seiner Längsachse drehbar angeordnet ist. Dabei kann der erste Abschnitt des Trägers und der Längsstreifen des dritten Abschnitts des Trägers zum Innenteil ortsfest angeordnet sein, während der Querstreifen des dritten Abschnittes des Trägers zum Innenteil aufwickelbar bzw. abwickelbar angeordnet sein kann zur Bereitstellung einer Drehbarkeit des Innenteils um dessen Längsachse und damit insbesondere zur Bereitstellung einer Gasfunktion des Griffs. In dieser Ausführungsform kann der dritte Abschnitt des Trägers bzw. der Leiterplatte an Anschlusseinrichtung sowie Leiterbahnen zum elektrischen Verbinden der jeweiligen Kontakte der Anschlusseinrichtung mit der Sensorschaltung, der Sensorelektrode und/oder der Widerstandsbahn der Heizung aufweisen, sodass die Notwendigkeit zur Herstellung von nachträglichen elektrischen Verbindungen von Leitern oder Bauteilen beim Zusammenbau des erfindungsgemäßen Handgriffs ausgehend von der Anschlusseinrichtung entfallen kann. Insofern kann vorgesehen sein, dass der Träger und damit die Leiterplatte umfassend die beschriebenen ersten, zweiten und dritten Abschnitte als einstückiger Träger bzw. Leiterplatte ausgebildet sein kann, wodurch die Montage des Erfindungsgemäßen Handgriffs wesentlich vereinfacht ist.

Zur Gestaltung einer Leiterplatte, die in zumindest einem vorgegebenen, insbesondere dem ersten Abschnitt flexibel, d.h. biegsam ausgebildet ist, kann vorgesehen sein, eine im Wesentlichen herkömmlich gestaltete, starre Leiterplatte in diesem vorgegebenen Abschnitt bezüglich ihrer Dicke auszudünnen, insbesondere mittels einer Tiefenfräsung, sodass in diesem Abschnitt bezüglich seiner Dickenerstreckung der Leiterplatte die Trägerlage mit darauf angeordneten Leiterbahnen und elektronischen Bauteilen verbleibt, die Verstärkungslage jedoch entfernt ist.

In einer Ausführungsform kann die an sich flexible Trägerlage z.B. eine Polyamid-, oder eine Polyimidschicht sein. In einer besonders zweckmäßigen Ausführungsform kann vorgesehen sein, dass die Trägerlage eine Faser, insbesondere eine Faserstruktur wie eine Glasfaserstruktur aufweist, beispielsweise in Form eines Glasfasergewebes. Eine solche flexible Trägerlage kann je nach Ausführungsform insbesondere eine Dicke zwischen 100 µm und 300 µm, beispielsweise etwa 200 µm aufweisen. Eine starre Verstärkungslage bzw. eine starre Verstärkungslagensandwichstruktur kann beispielsweise eine Dicke zwischen 500 µm und 2000 µm, beispielsweise etwa 1500 µm aufweisen

Insbesondere bei solchen Ausführungsformen, bei welchen zusätzlich zu der Sensorelektrode zumindest eine Widerstandsbahn zur Bereitstellung einer Heizungsfunktion auf der flexiblen Leiterplatte angeordnet ist, kann zweckmäßigerweise vorgesehen sein, eine Temperatursensorschaltung auf der Leiterplatte anzuordnen. Der Temperatursensor umfasst neben der Temperatursensorschaltung ein mit dieser verbundenes Temperaturelement, beispielsweise ein PTC- oder NTC-Element, dass auf der Leiterplatte angeordnet sein kann, wobei die Temperatursensorschaltung zur Erfassung der Ist-Temperatur des Handgriffs im Bereich oder innerhalb des Verkleidungselementes angeordnet sein kann. Dabei kann vorgesehen sein, dass die Temperatursensorschaltung zumindest abschnittsweise, insbesondere mit allen elektronischen Bauteilen, z.B. in gleicher Weise wie die Näherungssensorschaltung, auf einem zur Längsachse des Innenteils umgeschwenkten Abschnitt der Leiterplatte angeordnet ist, wobei dieser Abschnitt der Leiterplatte in einer ringförmigen Radialwulst des Verkleidungselementes eingebettet sein kann. Dabei kann vorgesehen sein, dass die Näherungssensorschaltung sowie die Temperatursensorschaltung auf dem gleichen, zur Längsachse des Innenteils umgeschwenkten Abschnitt der Leiterplatte angeordnet sind, wobei dieser Abschnitt der Leiterplatte je nach Ausführungsform flexibel oder starr ausgebildet sein kann je nach Gestaltung des zweiten Abschnittes der Leiterplatte mit oder ohne Vorsehen einer Verstärkungslage zur Trägerlage.

In einer Ausführungsform kann vorgesehen sein, dass die Temperatursensorschaltung einen Mikrocontroller umfasst, der in einer besonders zweckmäßigen Ausführungsform identisch mit dem obenstehend angegebenen Mikrocontroller der Näherungssensorschaltung sein kann. In dieser Ausführungsform kann der Mikrocontroller eingerichtet und ausgebildet sowohl ein Näherungssensorsignal (Präsenzsignal) und/oder ein zugeordnetes Steuersignal als auch ein Temperatursignal zu ermitteln, das intern verarbeitet und/oder über die Anschlusseinrichtung an externe Einrichtungen wie eine zentrale Steuereinrichtung weitergebar ist.

Es sei bemerkt, dass in allen obigen Ausführungsformen des erfindungsgemäßen Handgriffs, in welchen ein Mikrocontroller zur Anwendung kommt, im Rahmen der Erfindung statt eines Mikrocontrollers ein integrierter Schaltkreis einsetzbar ist.

Vorzugsweise kann vorgesehen sein, dass auf der Leiterplatte eine Steuereinrichtung eingerichtet und ausgebildet ist, in Abhängigkeit eines Ausgangssignals der Näherungssensorschaltung und/oder in Abhängigkeit eines Ausgangssignals der Temperatursensorschaltung eine Steuersignal auszugeben, insbesondere an einem zugeordneten Kontakt der Anschlusseinrichtung, der wie beschrieben als Bus-Kontakt ausgebildet sein kann. Vorzugsweise kann diese Steuereinrichtung durch den obenstehend mit Bezug auf die Näherungssensorschaltung bzw. die Temperatursensorschaltung vorgesehenen Mikrocontroller umfassen bzw. durch diesen bereitgestellt sein.

Zur Erweiterung der Funktionalität des erfindungsgemäßen Handgriffs kann zweckmäßigerweise vorgesehen sein, dass die auf der Leiterplatte angeordnete Steuereinrichtung angeordnet und eingerichtet ist, eine über einen vorgegebenen Zeitraum erfasste Präsenzsignalabfolge mit zumindest einem vorgegebenen, insbesondere in einem Speicher abgelegten Signalmuster wie einer Signalabfolge zu vergleichen und in Abhängigkeit des Vergleichs ein Steuersignal zum Steuern einer Betriebsfunktionalität, insbesondere zum Starten der Heizfunktion am Handgriff, abzugeben. Es sei bemerkt, dass diese Betriebsfunktion sich allgemein auf das Fahrzeug beziehen kann und nicht auf eine Funktionalität des Handgriffs beschränkt sein muss. Beispielsweise kann ein durch Vergleich eines Signalmusters erzeugtes Steuersignal zur Steuerung einer Bremsfunktion ausgebildet sein. Zu diesem Zweck kann vorgesehen sein, dass das an einer elektrischen Anschlusseinrichtung abgegebene Steuersignal in Betrieb einer zentralen Steuereinrichtung des Motorfahrzeuges zuführbar ist.

Zum Anschluss des erfindungsgemäßen Handgriffs an einen Steuerbus des Motorfahrzeuges, kann zweckmäßigerweise vorgesehen sein, dass der Signalkontakt der Anschlusseinrichtung als Ein- und/oder Ausgangskontakt einer insbesondere zum bidirektionalen Datenaustausch eingerichteten BusSchnittstelle ausgebildet ist, die eingerichtet und ausgebildet ist zum Übertragen von Signalen, insbesondere Präsenzsignalen, Temperatursignalen und/oder Steuersignalen an einen Bus des Motorfahrzeuges, insbesondere einen CAN-Bus.

In einer besonders zweckmäßigen Ausführungsform kann auch vorgesehen sein, dass die auf der Leiterplatte angeordnete Sensorelektrode des Näherungssensors, die sich im Wesentlichen vollumfänglich und über einen mehr als 50%-igen Anteil der Längserstreckung des Innenteils erstrecken kann, darüber hinaus bezüglich ihrer physikalischen Eigenschaften als elektrische Widerstandsbahn ausgebildet ist zur Erzeugung von Verlustwärme durch Anlegen einer von einer Versorgungschaltung bereitgestellten Heizungsspannung. Insofern ist in dieser Ausführungsform die Näherungssensorelektrode gleichzeitig als Widerstandsbahn einer Widerstandsheizung ausgebildet, sodass dieser auf dem flexiblen Abschnitt der Trägerlage angeordneter Leiterabschnitt sowohl einen Abschnitt des Näherungssensors als auch einen Abschnitt der Heizungsfunktionalität bzw. - -einrichtung am erfindungsgemäßen Handgriff darstellt. In dieser Ausführungsform kann die Sensorelektrode bzw. die Widerstandsbahn mittels entsprechenden elektronischen Weichen, insbesondere Frequenzweichen, an die Näherungssensorschaltung bzw. an eine Versorgungsschaltung der Heizung, angeschlossen sein. Zur Bereitstellung einer Differenzierbarkeit der Signale können die Näherungsschaltung und die Versorgungsschaltung eingerichtet und ausgebildet sein, bei unterschiedlichen Betriebsfrequenzen zu arbeiten.

Die Erfindung betrifft ferner ein Verfahren zum Betrieb eines Handgriffs für einen Lenker eines Motorfahrzeuges, insbesondere eines obenstehend beschriebenen erfindungsgemäßen Handgriffs für einen Lenker eines Motorfahrzeuges, wobei von einer auf der flexiblen Leiterplatte angeordnete Steuereinrichtung oder von einer zentralen Steuereinrichtung des Motorfahrzeuges, eine, über einen vorgegebenen Zeitraum erfasste Präsenzsignalfolge mit zumindest einem vorgegebenen, insbesondere abgespeicherten Signalmuster (Muster einer Signalfolge) verglichen wird und in Abhängigkeit des Vergleichs beim Vorliegen einer Übereinstimmung nach vorgegebenen Kriterien ein Steuersignal ausgegeben wird zum Starten oder Einleiten einer Betriebsfunktion wie das Betreiben einer im Handgriff angeordneten Heizung, das Abbremsen des Motorfahrzeuges und/oder das Beschleunigen des Motorfahrzeuges. Diese Steuerung kann beispielsweise in einer im Handgriff, d.h. auf der flexiblen Leiterplatte angeordneten Steuereinrichtung und/oder durch eine zentrale, mit zumindest einer, auf der flexiblen Leiterplatte des Handgriffs angeordneten Schaltung elektrisch verbundenen zentralen Steuereinrichtung des Motorfahrzeugs eingeleitet oder gestartet werden. Beispielsweise kann vorgesehen sein, dass eine Mehrzahl von Mustern von Signalabfolgen abgespeichert werden, wobei die in einem vorgegebenen Zeitraum erfasste Präsenzsignalabfolge mit den abgespeicherten Mustern nach vorgegebenen Kriterien verglichen wird und wenn der Vergleich einen vorgegebenen Schwellgrad einer Ähnlichkeit nach den vorgegebenen Kriterien erreicht, eine diesem identifizierten Signalmuster zugeordnete Betriebsfunktion eingeleitet oder gestartet wird. Vorzugsweise kann vorgesehen sein, dass ein solches Signalmuster eine vorgegebene zeitliche Abfolge von Präsenzsignalen umfasst, die eine mehrmalige Annäherung und Entfernung, beispielsweise einer Hand, zum Handgriff anzeigen. Es kann vorgesehen sein, dass die vorgegebenen Signalmuster in der Art eines Morsesignals gestaltet sind, das zwei unterschiedliche Signalwerte entsprechend "Präsenz ja"/"Präsenz nein" aufweisen kann, wobei die jeweilige Signaldauer eines jeweiligen Signalwertes wiederum zwei unterschiedliche Werte annehmen kann, entsprechen "kurz" und "lang". Dabei kann ein digitaler Signalwert "Präsenz ja" durch Unterschreiten einer vorgegebenen ersten Näherungsschwelle und ein digitaler Signalwert "Präsenz nein" durch Überschreiten einer vorgegebenen zweiten Näherungsschwelle zum Handgriff und die jeweilige Signaldauer durch Beibehaltung der jeweiligen relativen Anordnung der Hand zum Griff in der zu erzeugenden Präsenzsignalabfolge erfassbar sein. Zur Vermeidung eines instabilen Zustandes des Präsenzsignals können die erste vorgegebene und die zweite vorgegebene Näherungsschwelle unterschiedlich eingestellt sein.

Es kann jedoch auch vorgesehen sein, dass die vorgegebenen Signalmuster mehr als zwei, insbesondere drei oder vier unterschiedliche Signalwerte entsprechend "Präsenz 0" bis "Präsenz 3", die unterschiedlichen Nähen bzw. Abständen zum Handgriff zugeordnet sein können, aufweisen kann, wobei die jeweilige Signaldauer eines jeweiligen Signalwertes wiederum zumindest zwei unterschiedliche Werte annehmen kann, entsprechen "kurz" und "lang" im Fall von zwei unterschiedlichen Signaldauern.

Es kann vorgesehen sein, dass eine am Handgriff angeordnete Steuereinrichtung oder eine zentrale Steuereinrichtung des Motorfahrzeuges ausgebildet und eingerichtet ist, die Näherungssensorschaltung zu kalibrieren. Hierdurch kann beispielsweise das Antwortverhalten der Näherungssensorschaltung in Abhängigkeit der Hand des Fahrers und/oder des Materials eines vom Fahrer verwendeten Handschuhs berücksichtigt werden, sodass nach dieser Kalibrierung fehlerfrei eine Annäherung bzw. Präsenz der Hand des Fahrers zum Handgriff anzeigbar ist, unabhängig davon ob der jeweilige Fahrer einen Handschuh trägt oder nicht und unabhängig vom Material eines eventuell verwendeten Handschuhs. Hierzu kann vorgesehen sein, dass der erfindungsgemäße Handgriff eine Eingabeeinrichtung zum Starten eines Kalibriervorganges, zum Abspeichern eines Kalibrierwertes zur Erfassung einer Präsenz und/oder zur Auswahl eines jeweiligen Kalibrierwertes nach dem Kalibriervorgang aufweist. Ferner kann eine auf der Leiterplatte, insbesondere auf dem zweiten Abschnitt der Trägerlage angeordnete Steuereinrichtung ausgebildet und eingerichtet sein, das beschriebene Kalibrierverfahren in Abhängigkeit der obenstehend angegebenen Fahrereingaben durchzuführen.

Die Erfindung wird im Folgenden durch das Beschreiben einer Ausführungsform nebst Abwandlungen unter Bezugnahme auf die beiliegenden Zeichnungen erläutert, wobei
- Figur 1: in einer perspektivischen Ansicht ein Innenteil eines erfindungsgemäßen Handgriffs,
- Figur 2: eine Leiterplatte, die zur Gestaltung eines erfindungsgemäßen Handgriffs an eine Außenmantelfläche des Innenteils der Figur 1 anlegbar ist,
- Figur 3: in einer perspektivischen Prinzip- Querschnittsskizze einen fertiggestellten Handgriff mit angegossenem oder angespritztem Verkleidungselement, und
- Figur 4: eine zur Darstellung der Fig.2 alternative Ausführungsform einer Leiterplatte zur Gestaltung eines weiteren erfindungsgemäßen Handgriffs
zeigt.

Die nachfolgend beschriebene Ausführungsform eines erfindungsgemäßen Handgriffs für ein Motorrad umfasst zum einen Näherungssensor zur Erfassung einer Annäherung an den Handgriff und stellt zum anderen eine Heizungsfunktionalität bereit. Als wesentliche Bestandteile umfasst der erfindungsgemäße Handgriff ein Innenteil, eine an der Außenmantelseite des Innenteils angeordnete Leiterplatte, und ein radial au-ßen zur Außenmantelseite des Innenteils und zur daran anliegenden Leiterplatte angegossenes oder angespritztes Verkleidungselement, beispielsweise umfassend ein anvulkanisiertes Elastomer, angeordnet sein kann.

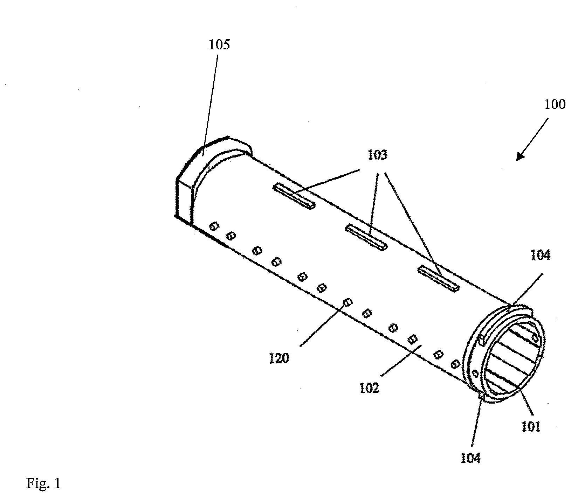

Figur 1 zeigt in einer perspektivischen Ansicht das hohlzylinderförmige Innenteil 100 zur Gestaltung eines erfindungsgemäßen Handgriffs. Das Innenteil 100 weist eine zylinderförmige innere Mantelfläche 101 und eine im Wesentlichen zylinderförmige äußere Mantelfläche 102 auf. Der innere Durchmesser des Innenteils ist so gemessen, dass dieses auf ein nicht dargestelltes Lenkstangenrohr des Motorrades aufschiebbar ist, wobei ein solches Lenkstangenrohr ein Metallrohr sein kann. In der beschriebenen Ausführungsform des erfindungsgemäßen Handgriffs weist das Innenteil an seiner äußeren Mantelfläche 102 umfänglich verlaufende Radialstege auf. Beispielsweise können diese Radialstege an dem in Einbaulage äußeren Ende des Innenteils in Form von zwei umfänglich beabstandete, radiale Ringsegmentstege 104 ausgebildet sein, wobei an dem gegenüberliegenden Längsende des Innenteils ein radialer Ringsteg 105 angeordnet sein kann, der sich insofern vollumfänglich an der Außenmantelseite des Innenteils erstreckt.

Der mittlere Bereich der Längserstreckung des Innenteils 100, der durch die angegebenen Radialstege 104, 105 beschränkt wird, ist zur Aufnahme bzw. Anlage einer noch im Einzelnen zu beschreibenden, in einem Abschnitt flexibel gestalteten Leiterplatte ausgebildet. Hierzu weist das Innenteil 100, an dessen äußerer Mantelfläche 102 mehrere in Längsrichtung des Innenteils beabstandete Längsstege 103 vorgesehen, die sich von der äußeren Mantelfläche radial nach außen erstrecken. Wie aus Figur 1 ersichtlich, verlaufen diese in Längsrichtung beabstandeten Längsstege 103 in der beschriebenen Ausführungsform auf einer gedachten Geraden auf der äußeren Mantelfläche des Innenteils etwa parallel zur Längsachse des Innenteils. Darüber hinaus weist das Innenteil 100 in der beschriebenen Ausführungsform, wiederum auf einer gedachten Geraden, parallel zur Längsachse auf der äußeren Mantelfläche 100, eine Mehrzahl von in Längsrichtung beabstandeten Zapfen 120 auf, die sich radial nach außen mit einer vorgegebenen Höhe erstrecken. Sowohl die sich radial von der äußeren Mantelfläche des Innenteils erstreckenden Längsstege 103 als auch die sich von der äußeren Mantelfläche 102 radial erstreckenden und in Längsrichtung auf einer Geraden angeordneten Zapfen 120 stellen Eingriffsmittel zur Bereitstellung eines Formschlusses zwischen dem Innenteil und einer daran direkt aufliegenden und das Innenteil umgreifenden und in diesem Abschnitt flexiblen Leiterplatte mit einem folienartigen Träger bzw. Trägerlage bereit.

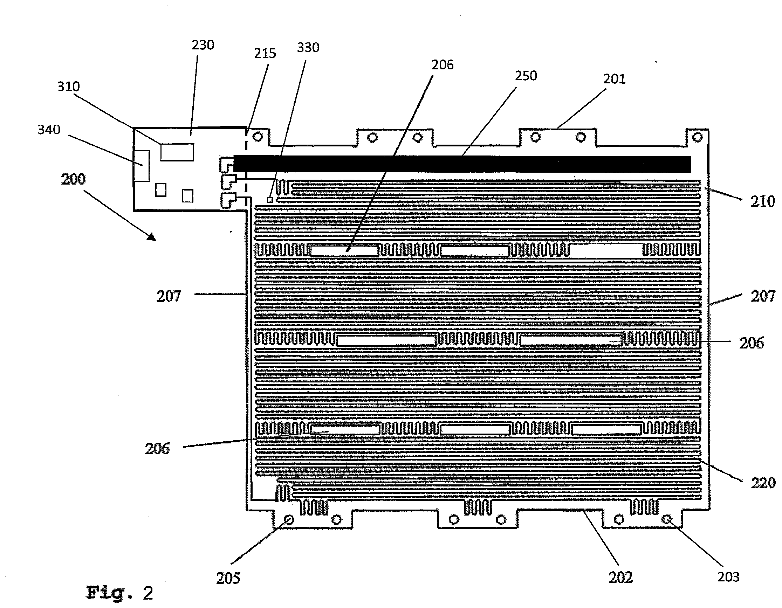

Figur 2 zeigt in einer Ausführungsform einer Leiterplatte 200 in einer Aufsicht. Auf einem Träger 210, der einen hochmolekularen Kunststoff wie Polyamid, Polyester, oder ein Glasfasergewebe aufweisen kann, ist eine mäanderförmige Widerstandsbahn 220 zur Gestaltung einer Widerstandsheizung, die in Einbaulage um das Innenteil herum angeordnet ist, ausgebildet. Die hier abschnittsweise flexible Leiterplatte 200 ist längsseitig durch Stirnkanten 207 beschränkt, während sie umfänglich zwei in Einbaulage ineinandergreifende, verzahnte Längskanten 201, 202 aufweist. Neben der Widerstandsbahn 220 ist auf dem flexiblen Abschnitt der Leiterplatte 200 eine Näherungssensorelektrode 250 aufgebracht, die in der beschriebenen Ausführungsform im Wesentlichen über die gesamte Längserstreckung der flexiblen Leiterplatte 200 verlaufen kann. Der flexible Abschnitt der Leiterplatte 200 weist eine Mehrzahl von, insbesondere mit den radialen Längsstegen 103 des Innenteils (siehe Figur 1) in Einbaulage korrespondierende, schlitzförmige Ausnehmungen 206 auf, in welche die angegebenen Radialstege eingreifen zur Bereitstellung eines Formschlusses zwischen Innenteil 100 und Leiterplatte 200 in Einbaulage der beiden Bauteile.

Darüber hinaus sind die im Bereich der Zahnstruktur der Längskanten 201, 202 angeordneten Löcher 205 korrespondierend zu den in Längsrichtung beabstandet angeordneten und sich in radialer Richtung erstreckenden stiftartigen Vorsprünge oder Zapfen 120 ausgebildet, derartig, dass sich die Vorsprünge in Einbaulage jeweils durch ein zugeordnetes Loch 205 der Leiterplatte erstrecken und damit zum Formschluss zwischen Leiterplatte 200 und Innenteil 100 beitragen.

In der beschriebenen Ausführungsform weist die an sich rechteckige Leiterplatte 200 an einer ihrer Stirnkanten einen starren Fortsatz 230 auf als Abschnitt der Leiterplatte, auf welchem zumindest eine Sensorschaltung angeordnet ist, die elektrisch mit der Sensorelektrode 250 verbunden ist und zusammen mit dieser den kapazitiven Näherungssensor bildet. In der beschriebenen Ausführungsform kann der Näherungssensor einen Mikrocontroller 310 umfassen, der zusammen mit weiteren elektronischen Bauteilen ausgebildet und eingerichtet ist zur Ausgabe eines Präsenzsignals und/oder eines verarbeiteten Präsenzsignals in Form eines Steuersignals zum Steuern einer Betriebsfunktion des Handgriffs oder des Motorfahrzeuges. Die Starrheit der Leiterplatte im Bereich des Fortsatzes 230 wird durch Vorsehen einer durch die Perspektive in der Figur nicht zu erkennenden Verstärkungslage erzeugt, die direkt oder unter Vorsehen einer oder mehreren Zwischenlagen mit der an sich flexiblen Trägerlage verbunden sein kann. Demgegenüber weist ein erster Abschnitt der Trägerlage 210 bzw. der Leiterplatte 200, auf welchem die Widerstandsbahn 220 und die Sensorelektrode 250 angeordnet sind, keine derartige Verstärkungslage auf, und ist insofern flexibel, d.h. biegsam ausgebildet.

Bei dem hier kapazitiv arbeitenden Näherungssensor bildet die Sensorelektrode 250 einen Abschnitt eines Kondensators, der als frequenzbestimmendes Element in einem Oszillator der Sensorschaltung verschaltet ist. Dabei ist die Kapazität des Kondensators durch eine Annäherung an den Griff veränderlich, was zu einer zugeordneten Veränderung der Oszillatorfrequenz führt, die erfassbar ist und zur Ermittlung eines Präsenzsignal genutzt wird.

Dabei kann vorgesehen sein, dass die Sensorschaltung ausgebildet und angeordnet ist, ein digitales Präsenzsignal zu erfassen und auszugeben, insbesondere zur Anzeige einer Präsenz oder einer Nicht-Präsenz im Bereich des Handgriffs. Ferner kann auch vorgesehen sein, dass das ermittelte Präsenzsignal einen größeren Informationsgehalt aufweist, z.B. angibt, in welchem von mehreren, beispielsweise drei, vier oder fünf Abstandsabschnitten eine Annäherung oder Präsenz zum Handgriff vorliegt.

Auf der Leiterplatte 200 der Figur 2 ist ferner die Anordnung eines Temperatursensors 330 vorgesehen, welcher im Bereich der Widerstandsbahn 220 angeordnet ist und die Temperatur auf bzw. an der Leiterplatte 200 erfasst. Hierzu kann der Temperatursensor 330 zweckmäßigerweise mit einem Eingang des Mikrocontrollers 310 verbunden sein, zur Erfassung der Temperatur, beispielsweise durch die Erfassung eines erfassten temperaturabhängigen Widerstandes des Sensors.

Zum elektrischen Verbinden der Leiterplatte mit einer externen Versorgungseinrichtungen wie einer Batterie, sowie zur Weitergabe der ermittelten Präsenzsignalen, Steuersignalen und/oder Temperatursignalen an eine externe Steuereinrichtung des Motorfahrzeuges ist in der beschriebenen Ausführungsform vorgesehen, dass auf dem hier starren Abschnitt der Leiterplatte 230 eine Anschlusseinrichtung 340 angeordnet ist, die entsprechende Kontakte aufweist.

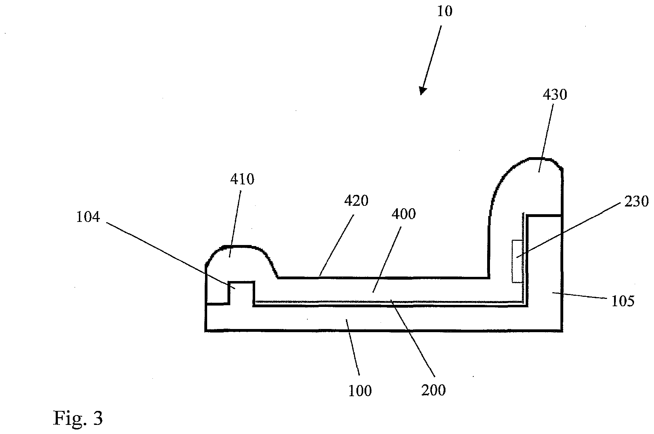

In der beschriebenen Ausführungsform weist die Anschlusseinrichtung 340 darüber hinaus Versorgungskontakte für die Widerstandsbahn 220 auf zum Einbringen der notwendigen elektrischen Leistung zur Erzeugung der Verlustleistung in die flexiblen Leiterplatte 200 bzw. in die dort anliegenden Bauteile, insbesondere in das Verkleidungselement, siehe Fig. 3.

In einer Abwandlung der beschriebenen Ausführungsform kann vorgesehen sein, dass der Mikrocontroller 310 eingerichtet und ausgebildet ist, einen auf der flexiblen Leiterplatte in einem Heizungsschaltkreis angeordneten elektrischen Schalter anzusteuern, um in Abhängigkeit einer über den Temperatursensor 330 gemessenen Temperatur und/oder in Abhängigkeit eines externen Steuersignals die Heizleistung, d. h. den Stromfluss durch die Widerstandsband 220 zu steuern.

Nach der Einstellung des Formschlusses zwischen dem Innenteil 100 und dem flexiblen Abschnitt der Leiterplatte 200 durch Anlage der Leiterplatte an die äußere Mantelfläche 102 des Innenteils 100, derart, dass sich radial verlaufende Stege 103 bzw. radial verlaufende Zapfen 120 des Innenteils durch zugeordnete Öffnungen wie Lochabschnitte oder Ausnehmungen 206 bzw. Löcher 205 erstrecken, kann ein Verkleidungselement 400 angegossen oder angespritzt werden. Der erfindungsgemäß ausgebildete Handgriff ist in einer Teilschnittdarstellung, wobei die Längsachse des Innenteils in der Schnittebene liegt, in Figur 3 angegeben. Erkennbar ist zur Gestaltung der gegenseitigen Anlage von Leiterplatte und Innenteil der obenstehend als Fortsatz 230 beschriebene Abschnitt der Leiterplatte, welcher in der beschriebenen Ausführungsform zumindest einige der elektronischen Bauteile der Sensorschaltung trägt, an einer im flexiblen Bereich der Leiterplatte liegenden Scharnierachse 215 um etwa 90° in radialer Richtung zum Rest der Leiterplatte 200 umgeschwenkt. Dabei kann vorgesehen sein, dass dieser Schaltungsabschnitt der Leiterplatte an dem radialen Ringsteg 105 anliegt bzw. von diesem abgestützt ist. Vorzugsweise ist auch der Abschnitt 230 der Leiterplatte an der diesen zugewandten Längsseite des radialen Ringstegs 105 befestigt, insbesondere formschlüssig.

Das Anspritzen des Verkleidungselements 400 erfolgt in einer Spritzgießform, die so ausgebildet ist, dass im Bereich der Längsenden des Verkleidungselements 400 und damit im Bereich des Ringelements 105 bzw. im Bereich der radialen Ringsegmentstege 104 und des radialen Ringstegs 105 umfänglich umlaufende Flansche oder Wülste 410, 430 angeformt sind, zwischen welchen sich der zylinderförmige Griffabschnitt 420 erstreckt, und der vom Fahrer mit seiner Hand in einer üblichen Betriebsstellung umgriffen ist. Die Angabe "Flansch" meint dabei einen Abschnitt des Verkleidungselements 400, welcher eine größere radiale Erstreckung als die radiale Abmessung innerhalb des Griffabschnitts 420 aufweist, insbesondere zumindest eine 120 - 130ö-fache radiale Erstreckung im Vergleich zu der des Griffabschnittes 420. Erkennbar ist in der beschriebenen Ausführungsform der um etwa 90° zum Restabschnitt der Leiterplatte 200 umgeschwenkte Abschnitt 230 vollständig im Material des Verkleidungselements 400 eingebettet und damit geschützt. In der beschriebenen Ausführungsform sind entsprechend der Anzahl der Kontakte der Anschlusseinrichtung 340 eine Mehrzahl von elektrischen Leitungen, beispielsweise mittels Lötens, angebracht und erstrecken sich durch den Flansch 430 des Verkleidungselements 400 in Längsrichtung nach außen zum Verbinden mit einer elektrischen Versorgungseinrichtung sowie einer zentralen Steuereinrichtung des Motorfahrzeuges, was in Figur 3 nicht dargestellt ist.

In einer nicht dargestellten Ausführungsform des erfindungsgemäßen Handgriffs kann auch vorgesehen sein, dass die Sensorschaltung sowie die Anschlusseinrichtung 340 in einem Abschnitt der Leiterplatte angeordnet sind, die an der im Wesentlichen zylinderförmigen äußeren Mantelfläche 102 des Innenteils 100 anliegt, sodass kein umgeschwenkter Abschnitt der Leiterplatte vorliegt und die gesamte Leiterplatte über im Wesentlichen gesamte Flächenerstreckung flexibel sein kann. Auch in dieser Ausführungsform können Leitungen im Bereich der Flansche 410, 430 aus dem Verkleidungselement heraustreten zum Anschluss an externe Einrichtungen wie Versorgungseinrichtung und/oder zentrale Steuereinrichtung. Darüber hinaus kann auch vorgesehen sein, zumindest die auf dem Abschnitt 230 der Leiterplatte 200 angeordnete Anschlusseinrichtung 340, beispielsweise im Bereich eines Längsendabschnittes des erfindungsgemäßen Handgriffs zugänglich anzuordnen, sodass eine externe und komplementär zur Anschlusseinrichtung 340 aufgebaute Einrichtung mit dieser mechanisch und elektrisch verbindbar ist.

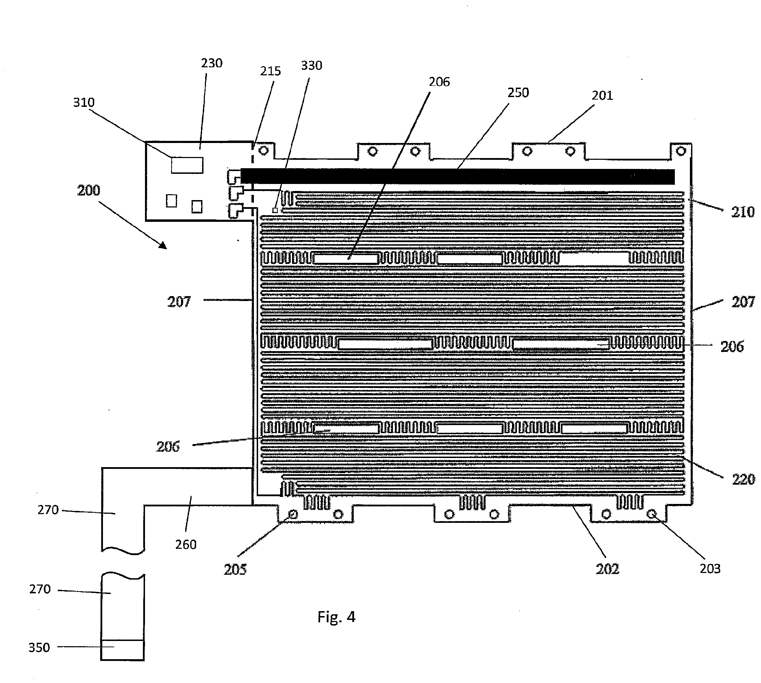

Figur 4 zeigt eine weitere Ausführungsform einer Leiterplatte 200' in einer Aufsicht, welche mit Ausnahme der Anordnung der Anschlusseinrichtung identisch mit der Leiterplatte der Figur 2 ausgebildet ist. Zur Vermeidung von Wiederholungen, wird im Folgenden allein auf diese Unterschiede eingegangen. Statt der auf dem Fortsatz 230 angeordneten Anschlusseinrichtung 340 gemäß der Ausführungsform der Figur 2, weist die in Figur 4 angegebene, wiederum einstückige Leiterplatte einen dritten Abschnitt des Trägers und damit der Leiterplatte 200' auf, der sich von dem, in Einbaulage am zylinderförmigen Außenmantelabschnitt des Innenteils anliegenden ersten Abschnittes des Trägers erstreckt und wie dieser erste Abschnitt flexibel ausgebildet ist, sodass die Leiterplatte im genannten ersten und im dritten Abschnitt flexibel ausgebildet ist. Dieser dritte Abschnitt des Trägers bzw. der Leiterplatte umfasst einen etwa parallel zur Längsachse des Innenteils erstreckenden Längsstreifen 260 und einen sich daran anschließenden und mit einem Winkel von 90° zum Längsstreifen abgehenden Querstreifen 270, der sich in Einbaulage umfänglich um das Innenteil, siehe Figur 1, herumgewickelt erstreckt, an dessen freiem Ende die Anschlusseinrichtung, hier in Form eines Anschlusssteckers 350, beispielsweise zum Verbinden mit einer externen Stromversorgung und/oder einer zentralen Steuereinrichtung, angeordnet ist.

In einer Ausführungsform eines erfindungsgemäß gestalteten Handgriffs kann vorgesehen sein, dass der erste Abschnitt des Trägers und der Längsstreifen des dritten Abschnittes des Trägers bzw. der Leiterplatte zum Innenteil 100 ortsfest angeordnet sind, während der Querstreifen 270 des dritten Abschnittes des Trägers zum Innenteil aufwickelbar bzw. abwickelbar angeordnet ist zur Bereitstellung einer Drehbarkeit des Innenteils um dessen Längsachse und damit zur Bereitstellung einer Gasfunktion des erfindungsgemäßen Handgriffs. Bei dieser Ausführungsform weist der dritte Abschnitt des Trägers bzw. der Leiterplatte die Anschlusseinrichtung 350 sowie Leiterbahnen zum elektrischen Verbinden der jeweiligen Kontakte der Anschlusseinrichtung mit der Sensorschaltung, der Sensorelektrode 250 sowie der Widerstandsleiterbahn 220 auf, die der Einfachheit halber in Figur 4 nicht dargestellt sind.

### Bezugszeichenliste

- 10: Handgriff
- 100: Innenteil
- 101: Innere Mantelfläche
- 102: Äußere Mantelfläche
- 103: Längssteg, Vorsprung
- 104: Radialer Ringsegmentsteg
- 105: Radialer Ringsteg
- 120: Vorsprung, Zapfen
- 200, 200': Leiterplatte
- 201, 202: Längskante
- 205: Loch, Lochabschnitt
- 206: Lochabschnitt, Ausnehmung
- 207, 208: Stirnkante
- 210: Träger, Trägerlage
- 215: Scharnierachse
- 220: Widerstandsbahn
- 230: Fortsatz
- 250: Sensorelektrode
- 260: Längsstreifen
- 270: Querstreifen
- 300: Elektrische Schaltung
- 310: Mikrocontroller
- 330: Temperatursensor
- 340: Anschlusseinrichtung
- 350: Anschlussstecker
- 400: Verkleidungselement
- 410: Wulst/Radialwulst
- 420: Griffabschnitt
- 430: Wulst/Radialwulst

## Patentansprüche

1. Handgriff (10) für einen Lenker eines Motorfahrzeuges wie ein Motorrad, Wassermotorrad, Motorschlitten, Quad, umfassend ein hohlzylinderartiges Innenteil (100) mit einer Außenmantelseite und einer Innenmantelseite, eine radial außen zur Außenmantelseite des Innenteils angeordnete Sensorelektrode (250) eines Näherungssensors, sowie ein radial außen zur Außenmantelseite des Innenteils (100) angeordnetes, angegossenes oder angespritztes Verkleidungselement (400), welches die Sensorelektrode abdeckt, wobei eine Näherungssensorschaltung mit der Sensorelektrode elektrisch verbunden ist,
**dadurch gekennzeichnet, dass** sowohl die Sensorelektrode (250) als auch die Näherungsensorschaltung auf einem gemeinsamen Träger (210) einer Leiterplatte (200, 200') angeordnet sind, wobei der gemeinsame Träger das Innenteil (100) umgreift, und mit zumindest einem ersten Abschnitt, in welchem der Träger flexibel ausgebildet ist, direkt oder indirekt an einem zylinderförmigen Außenmantelflächenabschnitt des Innenteils (100) anliegt und das Innenteil an seiner Außenmantelseite zumindest einen radial nach außen weisenden Vorsprung (103, 120) aufweist, der sich durch einen zugeordneten Lochabschnitt (205, 206) des ersten Abschnittes des Trägers der Leiterplatte erstreckt.

2. Handgriff (10) nach Anspruch 1, **gekennzeichnet durch** eine außerhalb oder zumindest abschnittsweise innerhalb des Verkleidungselements (400) angeordnete und mit der Leiterplatte (200, 200') elektrisch verbundenen elektrische Anschlusseinrichtung (340), die ausgebildet ist zum elektrischen Verbinden der Näherungssensorschaltung mit einer externen Versorgungsquelle, wobei vorzugsweise
die Anschlusseinrichtung (340) zumindest drei elektrische Kontakte aufweist umfassend zwei Versorgungskontakte und zumindest einen Signalkontakt, insbesondere zur Signalausgabe eines Präsenzsignals und/oder eines Steuersignals.

3. Handgriff (10) nach einem der Ansprüche 1 oder 2,
**dadurch gekennzeichnet, dass** die Näherungssensorschaltung einen Mikrocontroller (310) oder einen integrierten Schaltkreis aufweist, der ausgebildet und angeordnet ist, die Sensorelektrode (250) des Näherungssensors abzutasten und ausgangsseitig ein Präsenzsignal auszugeben.

4. Handgriff (10) nach einem der Ansprüche 1 bis 3,
**dadurch gekennzeichnet, dass** das Innenteil (100) an seiner Außenmantelseite zumindest einen radial nach außen weisenden und sich umfänglich erstreckenden Steg (104, 105) aufweist, der im Verkleidungselement (400) eingebettet ist und sich durch einen zugeordneten Lochabschnitt im ersten Abschnitt des Trägers (210) erstrecken kann.

5. Handgriff (10) nach einem der Ansprüche 1 bis 4,
**dadurch gekennzeichnet**, **das** s ein weiterer, von der Sensorelektrode (250) isoliert angeordneter Leiterbahnabschnitt auf dem ersten Abschnitt des Trägers angeordnet ist, der einer Heizungsfunktion zugeordnet ist und zumindest eine Widerstandsbahn (220) zur Erzeugung elektrischer Verlustwärme umfasst, wobei vorzugsweise
die elektrische Anschlusseinrichtung (340) ferner zumindest einen Heizungskontakt aufweist, der mit der zumindest einen Widerstandsbahn (220) elektrisch verbunden sind.

6. Handgriff (10) nach einem der Ansprüche 1 bis 5,
**dadurch gekennzeichnet, dass** die Näherungssensorschaltung auf einem zweiten Abschnitt des Trägers (210) der Leiterplatte (220) angeordnet ist, der zu dem, am zylinderförmigen Außenmantelflächenabschnitt des Innenteils anliegenden ersten Abschnitt des Trägers der Leiterplatte umgeschwenkt ist.

7. Handgriff (10) nach einem der Ansprüche 1 bis 6,
**dadurch gekennzeichnet, dass** die den zur Sensorelektrode (250) und Näherungsensorschaltung gemeinsamen Träger aufweisende Leiterplatte zumindest einen starren Abschnitt aufweist, in welchem der gemeinsame Träger mit zumindest einer starren Verstärkungslage verbunden ist, insbesondere stoffschlüssig.

8. Handgriff (10) nach einem der Ansprüche 1 bis 7,
**dadurch gekennzeichnet, dass** die Näherungssensorschaltung zumindest abschnittsweise im Bereich eines Längsendes des Innenteils an oder in einer Radialwulst (410, 430) des Verkleidungselementes (400) angeordnet ist, wobei vorzugsweise
die Näherungssensorschaltung im Bereich eines Längsendes des Innenteils an der Radialwulst (410, 430) des Verkleidungselementes kraft- oder formschlüssig befestigt ist.

9. Handgriff (10) nach Anspruch 8, **dadurch ge- kennzeichnet**, dass die Näherungssensorschaltung im Bereich eines Längsendes des Innenteils an einer Radialwulst (410, 430) des Verkleidungselementes in einem Angießprozess umgossen ist.

10. Handgriff (10) nach einem der Ansprüche 1 bis 9,
**dadurch gekennzeichnet, dass** das Innenteil an seiner Außenmantelseite mehrere radial nach außen weisende Vorsprünge (120) aufweist, wobei die Vorsprünge zueinander an der Außenmantelseite des Innenteils in Längsrichtung beabstandet angeordnet sind und sich durch einen jeweiligen zugeordneten Lochabschnitt (205) des Trägers (210) erstrecken können.

11. Handgriff (10) nach einem der Ansprüche 1 bis 10,
**dadurch gekennzeichnet**, das s eine Temperatursensorschaltung auf der Leiterplatte (200) angeordnet ist.

12. Handgriff (10) nach einem der Ansprüche 1 bis 11,
**dadurch gekennzeichnet**, das s eine auf der Leiterplatte (200, 200') angeordnete Steuereinrichtung eingerichtet und angeordnet ist, in Abhängigkeit eines Ausgangssignals der Näherungssensorauswerteschaltung und/oder in Abhängigkeit eines Ausgangssignals der Temperatursensorschaltung ein Steuersignal auszugeben, wobei vorzugsweise
die auf der Leiterplatte (200, 200') angeordnete Steuereinrichtung eingerichtet ist, über einen vorgegebenen Zeitraum erfasste Präsenzsignale mit zumindest einem vorgegebenen Signalmuster zu vergleichen und in Abhängigkeit des Vergleichs ein Steuersignal abzugeben, insbesondere zum Starten der Heizfunktion am Handgriff (10) .

13. Handgriff (10) nach einem der Ansprüche 2 bis 12,
**dadurch gekennzeichnet, dass** der Signalkontakt als Ein- und/oder Ausgangskontakt einer Busschnittstelle ausgebildet ist, die eingerichtet und ausgebildet ist zum Übertragen von Signalen, insbesondere Präsenzsignalen, Temperatursignalen und/oder Steuersignalen an einen Bus des Motorfahrzeuges.

14. Verfahren (10) zum Betrieb eines Handgriffs nach einem der Ansprüche 1 bis 13, wobei von einer auf der Leiterplatte (200, 200') angeordnete Steuereinrichtung oder von einer zentralen Steuereinrichtung des Motorfahrzeuges, eine über einen vorgegebenen Zeitraum erfasste Präsenzsignalfolge mit zumindest einem vorgegebenen Signalmuster verglichen wird und in Abhängigkeit des Vergleichs beim Vorliegen einer Übereinstimmung nach vorgegebenen Kriterien ein Steuersignal abgegeben wird zum Starten oder Einleiten einer Betriebsfunktion des Motorfahrzeuges.

## Claims

1. Handgrip (10) for a handlebar of a motor vehicle, such as a motorbike, water motorcycle, snowmobile, quad bike, comprising a hollow cylinder-like inner part (100) with an outer sheath side and an inner sheath side, a sensor electrode (250) of a proximity sensor, which sensor electrode is arranged radially on the outside of the outer sheath side of the inner part, and a covering element (400) which is arranged radially on the outside of the outer sheath side of the inner part (100) by overmolding or injection molding and which covers the sensor electrode, wherein a proximity sensor circuit is electrically connected to the sensor electrode, **characterized in that** both the sensor electrode (250) and the proximity sensor circuit are arranged on a common substrate (210) of a circuit board (200, 200'), wherein the common substrate surrounds the inner part (100) and, with at least a first section in which the substrate is flexibly formed, directly or indirectly bears against a cylindrical outer sheath surface section of the inner part (100), and the inner part has on its outer sheath side at least one radially outwardly pointing projection (103, 120) which extends through an associated hole portion (205, 206) of the first section of the substrate of the printed circuit board.

2. Handgrip (10) according to claim 1, **characterized by** an electrical connection device (340) which is arranged outside or, at least in sections, inside the covering element (400) and is electrically connected to the circuit board (200, 200'), which electrical connection device is configured to electrically connect the proximity sensor circuit to an external source of supply, wherein preferably
the connection device (340) has at least three electrical contacts which comprise two power contacts and one signal contact, in particular for the signal output of a presence signal and/or a control signal.

3. Handgrip (10) according to any one of claims 1 or 2, **characterized in that** the proximity sensor circuit comprises a micro controller (310) or an integrated circuit which is designed and arranged to scan the sensor electrode (250) of the proximity sensor and to output a presence signal on the output side.

4. Handgrip (10) according to any one of claims 1 to 3, **characterized in that** the inner part (100) has on its outer lateral side at least one radially outwardly facing and circumferentially extending web (104, 105) which is embedded in the covering element (400) and which can extend through an associated hole portion in the first section of the substrate (210).

5. Handgrip (10) according to any one of claims 1 to 4, **characterized in that** a further conductor track section arranged in an isolated manner from the sensor electrode (250) is arranged on the first section of the substrate which is associated with a heating function and comprises at least one resistance track (220) for generating electric heat loss, wherein preferably the electrical connection device (340) also has at least one heating contact that is electrically connected to the at least one resistance track (220).

6. Handgrip (10) according to any one of claims 1 to 5, **characterized in that** the proximity sensor circuit is arranged on a section of the substrate (210) of the circuit board (220) which is flipped over to the first section of the substrate of the printed circuit board that bears against the cylindrical outer lateral surface section of the inner part, of the substrate of the printed circuit board.

7. Handgrip (10) according to any one of claims 1 to 6, **characterized in that** the circuit board having the substrate common to the sensor electrode (250) and the proximity sensor circuit comprises at least one rigid section in which the common substrate is connected to at least one rigid reinforcing layer, in particular by a substance-to-substance bond.

8. Handgrip (10) according to any one of claims 1 to 7, **characterized in that** the proximity sensor circuit is arranged at least in sections in the region of a longitudinal end of the inner part on or in a radial bead (410, 430) of the covering element (400),
the proximity sensor circuit preferably being fastened in a force-fitting or form-fitting manner to the radial bead (410, 430) of the covering element in the region of a longitudinal end of the inner part.

9. Handgrip (10) according to claim 8, **characterized in that** the proximity sensor circuit is overmolded in a molding process in the region of a longitudinal end of the inner part on a radial bead (410, 430) of the covering element.

10. Handgrip (10) according to any one of claims 1 to 9, **characterized in that** the inner part has on its outer sheath side a plurality of projections (120) pointing radially outwards, wherein the projections are arranged at a distance from one another on the outer sheath side of the inner part in the longitudinal direction and can extend through a respective associated hole portion (205) of the substrate (210).

11. Handgrip (10) according to any one of claims 1 to 10, **characterized in that** a temperature sensor circuit is arranged on the circuit board (200).

12. Handgrip (10) according to any one of claims 1 to 11, **characterized in that** a control device disposed on the circuit board (200, 200') is configured and arranged to output a control signal as a function of an output signal of the proximity sensor evaluation circuit and/or as a function of an output signal of the temperature sensor circuit, wherein preferably
the control device disposed on the circuit board (200, 200') is configured to compare presence signals captured over a predetermined time period with at least one predetermined signal pattern and to output a control signal as a function of the comparison, in particular for starting the heating function on the handgrip (10).

13. Handgrip (10) according to any one of claims 2 to 12, **characterized in that** the signal contact is designed as an input and/or output contact of a bus interface arranged and configured to transmit signals, in particular presence signals, temperature signals and/or control signals, to a bus of the motor vehicle.

14. Method (10) for operating a hand grip according to any one of claims 1 to 13, wherein a control device arranged on the printed circuit board (200, 200') or a central control device of the motor vehicle compares a presence signal sequence detected over a predetermined period of time with at least one predetermined signal pattern and, depending on the comparison, a control signal is output for starting or initiating an operating function of the motor vehicle if there is a match according to predetermined criteria.

## Revendications

1. Poignée (10) pour le guidon d'un véhicule à moteur, tel qu'une moto, une moto aquatique, une motoneige, un quad, comprenant une partie intérieure creuse en forme de cylindre (100) avec un côté de gaine extérieure et un côté de gaine intérieure, une électrode de capteur (250) d'un capteur de proximité, laquelle électrode de capteur est disposée radialement à l'extérieur du côté de gaine extérieure de la partie intérieure, et un élément de recouvrement (400) qui est disposé radialement à l'extérieur du côté de gaine extérieure de la partie intérieure (100) par surmoulage ou moulage par injection et qui recouvre l'électrode de capteur, un circuit de capteur de proximité étant connecté électriquement à l'électrode du capteur,
**caractérisé en ce que** l'électrode du capteur (250) et le circuit du capteur de proximité sont disposés sur un substrat commun (210) d'une carte de circuit imprimé (200, 200'), dans lequel le substrat commun entoure la partie intérieure (100) et, avec au moins une première section dans laquelle le substrat est formé de manière flexible, s'appuie directement ou indirectement sur une section de surface de gaine extérieure cylindrique de la partie intérieure (100), et la partie intérieure présente sur son côté de gaine extérieure au moins une saillie (103, 120) orientée radialement vers l'extérieur, saillie qui s'étend à travers une partie de trou associée (205, 206) de la première section du substrat de la carte de circuit imprimé.

2. Poignée (10) selon la revendication 1, **caractérisée par** un dispositif de connexion électrique (340) disposé à l'extérieur ou, au moins en partie, à l'intérieur de l'élément de recouvrement (400) et connecté électriquement à la carte de circuit imprimé (200, 200'), lequel dispositif de connexion électrique est configuré pour connecter électriquement le circuit du capteur de proximité à une source d'alimentation externe, dans lequel de préférence
le dispositif de connexion (340) présente au moins trois contacts électriques, comprenant deux contacts d'alimentation et un contact de signal, en particulier pour la sortie d'un signal de présence et/ou d'un signal de commande.

3. Poignée (10) selon l'une quelconque des revendications 1 ou 2, **caractérisée en ce que** le circuit du capteur de proximité comprend un microcontrôleur (310) ou un circuit intégré qui est conçu et disposé pour balayer l'électrode (250) du capteur de proximité et pour émettre un signal de présence du côté de la sortie.

4. Poignée (10) selon l'une quelconque des revendications 1 à 3, **caractérisée en ce que** la partie intérieure (100) comporte sur son côté de gaine extérieur au moins une nervure (104, 105) orientée radialement vers l'extérieur et s'étendant sur la circonférence, qui est encastrée dans l'élément de recouvrement (400) et qui peut s'étendre à travers une section de trou associée dans la première section du substrat (210).

5. Poignée (10) selon l'une quelconque des revendications 1 à 4, **caractérisée en ce qu'**une autre section de piste conductrice disposée de manière isolée de l'électrode de capteur (250) est disposée sur la première section du substrat qui est associée à une fonction de chauffage et comprend au moins une piste de résistance (220) pour générer une perte de chaleur électrique,
le dispositif de connexion électrique (340) de préférence comportant également au moins un contact chauffant relié électriquement à la piste de résistance (220).

6. Poignée (10) selon l'une quelconque des revendications 1 à 5, **caractérisée en ce que** le circuit du capteur de proximité est disposé sur une section du substrat (210) de la carte de circuit imprimé (220) qui est pivotée sur la première section du substrat de la carte de circuit imprimé qui s'appuie sur la section de la surface de gaine extérieure cylindrique de la partie intérieure du substrat de la carte de circuit imprimé.

7. Poignée (10) selon l'une quelconque des revendications 1 à 6, **caractérisée en ce que** la carte de circuit imprimé ayant le substrat commun à l'électrode de capteur (250) et au circuit du capteur de proximité comprend au moins une section rigide dans laquelle le substrat commun est relié à au moins une couche de renforcement rigide, en particulier par une liaison substance à substance.

8. Poignée (10) selon l'une quelconque des revendications 1 à 7, **caractérisée en ce que** le circuit du capteur de proximité est disposé au moins en sections dans la région d'une extrémité longitudinale de la partie intérieure sur ou dans un bourrelet radial (410, 430) de l'élément de revêtement (400),
le circuit du capteur de proximité étant de préférence fixé de manière à s'adapter à la force ou à la forme au bourrelet radial (410, 430) de l'élément de revêtement dans la zone d'une extrémité longitudinale de la partie intérieure.

9. Poignée (10) selon la revendication 8, **caractérisée en ce que** le circuit du capteur de proximité est surmoulé dans un processus de moulage dans la région d'une extrémité longitudinale de la partie intérieure sur un bourrelet radial (410, 430) de l'élément de revêtement.

10. Poignée (10) selon l'une quelconque des revendications 1 à 9, **caractérisée en ce que** la partie intérieure présente sur son côté de gaine extérieure une pluralité de saillies (120) orientées radialement vers l'extérieur, les saillies étant disposées à distance les unes des autres sur le côté de gaine extérieure de la partie intérieure dans la direction longitudinale et pouvant s'étendre à travers une section de trou respective associée (205) du substrat (210).

11. Poignée (10) selon l'une quelconque des revendications 1 à 10, **caractérisée en ce qu'**un circuit de capteur de température est disposé sur la carte de circuit imprimé (200) .

12. Poignée (10) selon l'une quelconque des revendications 1 à 11, **caractérisée en ce qu'**un dispositif de commande disposé sur la carte de circuit imprimé (200, 200') est configuré et disposé pour émettre un signal de commande en fonction d'un signal de sortie du circuit d'évaluation du capteur de proximité et/ou en fonction d'un signal de sortie du circuit du capteur de température,
le dispositif de commande disposé sur la carte de circuit imprimé (200, 200') de préférence étant configuré pour comparer les signaux de présence capturés sur une période de temps prédéterminée avec au moins un modèle de signal prédéterminé et pour émettre un signal de commande en fonction de la comparaison, en particulier pour démarrer la fonction de chauffage sur la poignée (10).

13. Poignée (10) selon l'une quelconque des revendications 2 à 12, **caractérisée en ce que** le contact de signal est conçu comme un contact d'entrée et/ou de sortie d'une interface de bus agencée et configurée pour transmettre des signaux, en particulier des signaux de présence, des signaux de température et/ou des signaux de commande, à un bus du véhicule à moteur.

14. Procédé (10) de fonctionnement d'une poignée selon l'une quelconque des revendications 1 à 13, dans lequel un dispositif de commande disposé sur la carte de circuit imprimé (200, 200') ou un dispositif de commande central du véhicule automobile compare une séquence de signaux de présence détectée sur une période de temps prédéterminée avec au moins un modèle de signal prédéterminé et, en fonction de la comparaison, un signal de commande est émis pour démarrer ou initier une fonction de fonctionnement du véhicule automobile s'il y a une correspondance selon des critères prédéterminés.
